# EUROPÄISCHE PATENTSCHRIFT

(11) **EP 4 275 019 B1**
(45) Veröffentlichungstag und Bekanntmachung des Hinweises auf die Patenterteilung: **02.10.2024**
(21) Anmeldenummer: 21840833.4
(22) Anmeldetag: 16.12.2021
(51) Int. Cl.: G01F 23/26, G01R 33/26, G01F 23/284, G01F 23/292, G01R 33/032

(54) **SENSORVORRICHTUNG UND VERFAHREN ZUR BESTIMMUNG UND/ODER ÜBERWACHUNG EINER PROZESSGRÖSSE EINES MEDIUMS IN EINEM BEHÄLTER**
SENSOR DEVICE AND METHOD FOR DETERMINING AND/OR MONITORING A PROCESS VARIABLE OF A MEDIUM IN A CONTAINER
DISPOSITIF ET PROCÉDÉ DE DÉTECTION POUR LA DÉTERMINATION ET/OU LA SURVEILLANCE D'UNE VARIABLE DE PROCESSUS D'UN MILIEU DANS UN RÉCIPIENT

(30) Priorität: 08.01.2021 DE 102021100223
(43) Veröffentlichungstag der Anmeldung: 15.11.2023
(73) Patentinhaber: Endress+Hauser SE+Co. KG, 79689 Maulburg (DE); Universität Basel, 4001 Basel (CH)
(72) Erfinder: KUHNEN, Raphael, 79418 Schliengen (DE); EBRAHIMI, Mohammad Sadegh, 79539 Lörrach (DE); KÖLBL, Johannes, 4056 Basel (CH)
(74) Vertreter: Koslowski, Christine Adelheid
(86) Internationale Anmeldenummer: PCT/EP2021/086272
(87) Internationale Veröffentlichungsnummer: WO 2022/148633

(56) Entgegenhaltungen:
- WO-A1-2020/060694
- DE-A1- 102014 219 547
- DE-A1- 102017 205 099
- DE-A1- 102017 206 279
- DE-A1- 102018 214 617
- DE-A1- 3 341 265
- DE-A1- 3 726 411
- DE-U1- 202017 100 802
- JP-B2- 3 427 801

## Beschreibung

Die Erfindung betrifft eine Sensorvorrichtung zur Bestimmung und/oder Überwachung einer Prozessgröße eines Mediums in einem Behälter, sowie ein entsprechendes Verfahren.

Feldgeräte zur Überwachung und/oder Bestimmung mindestens einer, beispielsweise chemischen oder physikalischen, Prozessgröße eines Mediums sind in unterschiedlichsten Ausgestaltungen aus dem Stand der Technik bekannt. Im Rahmen der vorliegenden Anmeldung werden im Prinzip alle Messgeräte als Feldgerät bezeichnet werden, die prozessnah eingesetzt werden und die prozessrelevante Informationen liefern oder verarbeiten, also auch Remote I/Os, Funkadapter bzw. allgemein elektronische Komponenten, die auf der Feldebene angeordnet sind. Eine Vielzahl solcher Feldgeräte wird von Firmen der Endress + Hauser-Gruppe hergestellt und vertrieben.

Eine neuere Entwicklung im Bereich der Sensorik stellen sogenannte Quantensensoren dar, bei welchen unterschiedlichste Quanteneffekte zur Bestimmung verschiedener physikalischer und/oder chemischer Messgrößen ausgenutzt werden. Beispielsweise sind solche Ansätze im Bereich der industriellen Prozessautomatisierung insbesondere mit Hinblick auf ein zunehmendes Bestreben zur Miniaturisierung bei gleichzeitiger Steigerung der Leistungsfähigkeit der jeweiligen Sensoren interessant.

Aus der DE102017205099A1 ist eine Sensorvorrichtung mit einem Kristallkörper mit zumindest einer Fehlstelle, einer Lichtquelle, einer Hochfrequenzeinrichtung zum Beaufschlagen des Kristallkörpers mit einem Hochfrequenzsignal, und einer Detektionseinheit zur Detektion einer magnetfeldabhängigen Fluoreszenzsignals bekannt geworden. Die Lichtquelle ist auf einem ersten Substrat und die Detektionseinrichtung auf einem zweiten Substrat angeordnet, während die Hochfrequenzeinrichtung und der Kristallkörper auf beiden, miteinander verbundenen Subtraten angeordnet sein können. Als Messgrößen kommen externe Magnetfelder, elektrische Ströme, eine Temperatur, mechanische Spannungen oder ein Druck in Frage. Ausführlich diskutiert wird die Anwendung der Sensorvorrichtung zur Magnetfelderfassung, um damit eine berührungslose Strommessung zu realisieren. Durch ein zusätzliches Referenzmagnetfeld ist eine Kalibrierung der Sensorvorrichtung möglich.

Aus der unveröffentlichten Patentanmeldung DE 10 2020 123 993 ist eine Sensorvorrichtung bekannt geworden, welche auf einem Kristallkörper mit zumindest einer Fehlstelle beruht und das Fluoreszenzsignal des Kristallkörpers für die Bestimmung und/oder Überwachung einer Prozessgröße eines Mediums einsetzt. Es wird weiterhin offenbart, eine für das Magnetfeld charakteristische Größe, wie beispielsweise die magnetische Permeabilität oder magnetische Suszeptibilität, zu ermitteln und anhand dieser ermittelten charakteristischen Größe eine Zustandsüberwachung eines im Behälter ablaufenden Prozesses vorzunehmen. Für die Bestimmung eines Grenzstands wird beispielsweise ein Grenzwert für die für das Magnetfeld charakteristische Größe vorgegeben.

Die Aufgabe der vorliegenden Erfindung ist es daher, eine Sensorvorrichtung und ein Verfahren anzugeben, welche/s eine Prozessgröße eines Mediums auf einfache Weise zugänglich macht.

Hinsichtlich der Sensorvorrichtung wird die Aufgabe erfindungsgemäß gelöst durch eine Sensorvorrichtung zur Bestimmung und/oder Überwachung einer Prozessgröße eines Mediums in einem Behälter, umfassend
- einen Kristallkörper mit zumindest einer Fehlstelle,
- eine Magnetfeld-Einrichtung zur Erzeugung eines Magnetfelds, wobei die Magnetfeld-Einrichtung derart angeordnet ist, dass mittels der Magnetfeld-Einrichtung ein Magnetfeld im Bereich des Kristallkörpers und im Bereich des sich innerhalb des Behälters befindenden Mediums erzeugbar ist, so dass eine Änderung des Magnetfelds im Bereich des Kristallkörpers verstärkt wird, wobei der Kristallkörper und die Magnetfeld-Einrichtung von außen an einer Wandung des Behälters anordenbar sind,
- eine Anregeeinheit zur optischen Anregung der zumindest einen Fehlstelle,
- eine Detektionseinheit zur Detektion eines, magnetfeldabhängigen, Fluoreszenzsignals des Kristallkörpers,
- eine Auswerte-Einheit zum Ermitteln zumindest einer Aussage über die Prozessgröße anhand des Fluoreszenzsignals.

Die mindestens eine Fehlstelle im Kristallkörper wird mithilfe der Anregeeinheit optisch angeregt und das daraus resultierende Fluoreszenzsignal wird detektiert und ausgewertet. Das Fluoreszenzsignal des Kristallkörpers ist beeinflussbar durch Magnetfelder im Bereich des Kristallkörpers. So wird eine Änderung des Magnetfelds durch das Medium, wie eine Änderung des Gradienten des Magnetfelds, das Fluoreszenzsignal beeinflussen. Beispielsweise kann eine Änderung der magnetischen Permeabilität aufgrund einer Änderung des Mediums zu einer Änderung des Gradienten des Magnetfelds führen. Jedoch sind die Änderungen des Magnetfelds aufgrund der geringen Unterschiede der magnetischen Permeabilitäten verschiedener Medien in der Regel sehr klein, so dass der Effekt auf das Fluoreszenzsignals nur schwer messbar ist. Daher ist zusätzlich eine Magnetfeld-Einrichtung angeordnet, um eine Änderung des Magnetfelds im Bereich des Kristallkörpers zu verstärken. Somit kann die Änderung des, Gradienten des, Magnetfelds mithilfe des Fluoreszenzsignals ausgelesen und schließend die Prozessgröße anhand des Fluoreszenzsignals bestimmt und/oder überwacht werden, ohne dass eine Bestimmung einer magnetischen Permeabilität oder einer magnetischen Suszeptibilität nötig ist. Die erfindungsgemäße Sensorvorrichtung erlaubt damit eine sehr hohe Messgenauigkeit und Messauflösung von medienbedingten Änderungen des Magnetfelds.

Die Sensorvorrichtung ist weiterhin als eine frontbündig mit der Wandung des Behälters abschließende oder als eine nicht-invasive, vollständig außerhalb des Behälters befindliche, Vorrichtung ausgestaltet. Die Anregeeinheit kann beispielsweise einen Laser oder eine Leuchtdiode (LED) aufweisen. Bei der Detektionseinheit kann es sich beispielsweise um einen Photodetektor oder einen CMOS-Sensor handeln. Die Sensorvorrichtung kann weitere optische Elemente, wie beispielsweise Linsen, Spiegel oder Filter, umfassen.

Gemäß einer Ausgestaltung handelt es sich bei dem Kristallkörper um einen Diamanten mit zumindest einer Stickstoff-Fehlstelle, um Siliziumcarbid mit zumindest einer Silizium-Fehlstelle oder um hexagonales Bornitrid mit zumindest einem Fehlstellen-Farbzentrum handelt.

Der Kristallkörper umfasst erfindungsgemäß zumindest eine Fehlstelle. Es können jedoch auch mehrere Fehlstellen zum Einsatz kommen. In diesem Falle ist insbesondere eine lineare Anordnung der Fehlstellen bevorzugt. Mehrere Fehlstellen führen zu einer erhöhten Intensität, so dass die Messauflösung verbessert bzw. Intensitätsänderungen auch bei vergleichsweise schwachen Änderungen von Magnetfeldern detektierbar sind.

In einer weiteren Ausgestaltung weist die Magnetfeld-Einrichtung einen Permanentmagnet oder eine Spule auf. Der Kristallkörper kann zumindest teilweise innerhalb der Spule angeordnet sein.

Gemäß einer weiteren Ausgestaltung sind mindestens zwei Fehlstellen und/oder mindestens zwei Kristallkörper mit jeweils mindestens einer Fehlstelle linear und senkrecht zum Boden an der Wandung des Behälters anordenbar. Die mindestens zwei Fehlstellen und/oder die mindestens zwei Kristallkörper sind dabei derart angeordnet, dass eine Richtung der Änderung des Magnetfelds ermittelbar ist. Auf diese Weise kann eine vektorielle Ausrichtung des Magnetfelds ermittelt werden.

Vorteilhafterweise ist mindestens eine Lichtleitfaser zur Leitung des Anregesignals von der Anregeeinheit zum Kristallkörper und/oder zur Leitung des Fluoreszenzsignals des Kristallkörpers zur Detektionseinheit vorgesehen.

Bevorzugterweise ist die Sensorvorrichtung außerhalb des Behälters anordenbar. Nicht-invasive Vorrichtungen werden in der Prozessautomatisierung aus verschiedenen Gründen, wie beispielsweise Anforderungen an Hygiene und/oder Dichtigkeit, gegenüber invasiven Vorrichtungen bevorzugt. Bei einer nicht-invasiven Sensorvorrichtung verringert die Wandung des Behälters zwischen dem Medium und der Sensorvorrichtung die Empfindlichkeit der mindestens einen Fehlstelle gegenüber der Änderung des Magnetfelds, so dass die Anordnung der Magnetfeld-Einrichtung zur Verstärkung der Änderung des Magnetfels eine entscheidende Rolle spielt. Ohne die Magnetfeld-Einrichtung wäre die Bestimmung und/oder Überwachung der Prozessgröße im Falle einer nicht-invasiven Sensorvorrichtung nicht möglich.

In einer weiteren Ausgestaltung ist die Prozessgröße ein Füllstand und/oder ein Grenzstand des Mediums in dem Behälter. Bei der Bestimmung des Füllstands oder des Grenzstands des Mediums kommt es aufgrund der unterschiedlichen magnetischen Permeabilitäten von Medium und Luft an der Grenzfläche zwischen dem Medium und der darüber befindlichen Luft zu einer Änderung der magnetischen Permeabilität. Die Änderung der magnetischen Permeabilität erzeugt wiederum eine Änderung des Gradienten des magnetischen Feldes, welche durch die Magnetfeld-Einrichtung verstärkt und mittels des Kristallkörpers ausgelesen wird.

Die der Erfindung zugrunde liegende Aufgabe wird weiterhin gelöst durch ein Verfahren zur Bestimmung und/oder Überwachung einer Prozessgröße eines Mediums in einem Behälter mittels einer Sensorvorrichtung, wobei die Sensorvorrichtung umfasst:
- einen Kristallkörper mit zumindest einer Fehlstelle,
- eine Magnetfeld-Einrichtung zur Erzeugung eines Magnetfelds, wobei die Magnetfeld-Einrichtung derart angeordnet ist, dass mittels der Magnetfeld-Einrichtung ein Magnetfeld im Bereich des Kristallkörpers und im Bereich des sich innerhalb des Behälters befindenden Mediums erzeugbar ist und dass eine Änderung des Magnetfelds im Bereich des Kristallkörpers verstärkt wird, wobei der Kristallkörper und die Magnetfeld-Einrichtung von außen an einer Wandung des Behälters anordenbar sind,
- eine Anregeeinheit zur optischen Anregung der zumindest einen Fehlstelle,
- eine Detektionseinheit zur Detektion eines, magnetfeldabhängigen, Fluoreszenzsignals des Kristallkörpers,
- eine Auswerte-Einheit zum Ermitteln zumindest einer Aussage über die Prozessgröße anhand des Fluoreszenzsignals,
wobei das Verfahren mindestens die folgenden Verfahrensschritte aufweist:
- Erzeugen eines Magnetfelds im Bereich des Kristallkörpers und im Bereich des sich innerhalb des Behälters befindenden Mediums,
- Anregen der zumindest einen Fehlstelle,
- Detektieren eines Fluoreszenzsignals des Kristallkörpers,
- Ermitteln eines Gradienten des Magnetfelds anhand des Fluoreszenzsignals, und
- Ermitteln einer Aussage über die Prozessgröße anhand des Gradienten des Magnetfelds.

Durch eine Änderung des Mediums wird der Gradient des Magnetfelds beeinflusst. Beispielsweise unterscheidet sich typischerweise die magnetische Permeabilität des Mediums von der magnetischen Permeabilität der Luft, so dass an einer Grenzfläche zwischen Medium und Luft das durch die Magnetfeld-Einrichtung erzeugte Magnetfeld verzerrt wird und sich damit der Gradient des Magnetfelds ändert. Diese Änderung des Gradienten des Magnetfelds wird wiederum mittels des Fluoreszenzsignals der Fehlstelle detektiert und ausgewertet. Im Falle der Abwesenheit von Medium im Bereich des Kristallkörpers wird somit ein gleichbleibender Gradient des Magnetfelds und ein entsprechendes Fluoreszenzsignal erhalten. Sobald das Medium in den Bereich des Kristallkörpers auftritt und eine Grenzfläche mit der Luft ausbildet, wird eine Änderung des Gradienten des Magnetfelds mittels des Fluoreszenzsignals detektiert und es kann beispielsweise ein Grenzstand angegeben werden. Anstelle eines Grenzstands oder eines Füllstands kann beispielsweise auch eine chemische Reaktion oder eine Mischung von Medien im Behälter bestimmt werden.

Erfindungsgemäß wird keine magnetische Permeabilität des Mediums bestimmt, sondern eine Änderung der magnetischen Permeabilität im Bereich des Mediums. Damit entfällt das Vorgeben von Grenzwerten für beispielsweise den Grenzstand des Mediums im Behälter. Das erfindungsgemäße Verfahren ist für alle Arten von Medien einsetzbar, unabhängig von der Größenordnung ihrer magnetischen Permeabilität.

Gemäß einer Weiterbildung wird der Gradient des Magnetfelds anhand von mindestens zwei Fehlstellen und/oder mindestens zwei Kristallkörpern mit jeweils mindestens einer Fehlstelle ermittelt, welche linear und senkrecht zum Boden angeordnet sind. Die mindestens zwei Fehlstellen und/oder die mindestens zwei Kristallkörper sind dabei derart angeordnet, dass eine Richtung der Änderung des Gradienten des Magnetfelds ermittelbar ist. Auf diese Weise kann beispielsweise neben dem Grenzstand zusätzlich angegeben werden, ob das Medium im Behälter weiter steigt oder fällt. Damit ist auch eine Bestimmung des Füllstands möglich.

Die Erfindung wird anhand der nachfolgenden Figuren Fig. 1-6 näher erläutert werden. Sie zeigen:
Fig. 1: ein vereinfachtes Energieschema für ein negativ geladenes NV-Zentrum im Diamant.
Fig. 2: eine erste Ausgestaltung der erfindungsgemäßen Sensorvorrichtung.
Fig. 3: eine zweite Ausgestaltung der erfindungsgemäßen Sensorvorrichtung.
Fig. 4: eine dritte Ausgestaltung der erfindungsgemäßen Sensorvorrichtung.
Fig. 5: eine schematische Darstellung der Änderung des Magnetfelds an einer Grenzfläche zwischen dem Medium und Luft.
Fig. 6: eine schematische Darstellung des erfindungsgemäßen Verfahrens.

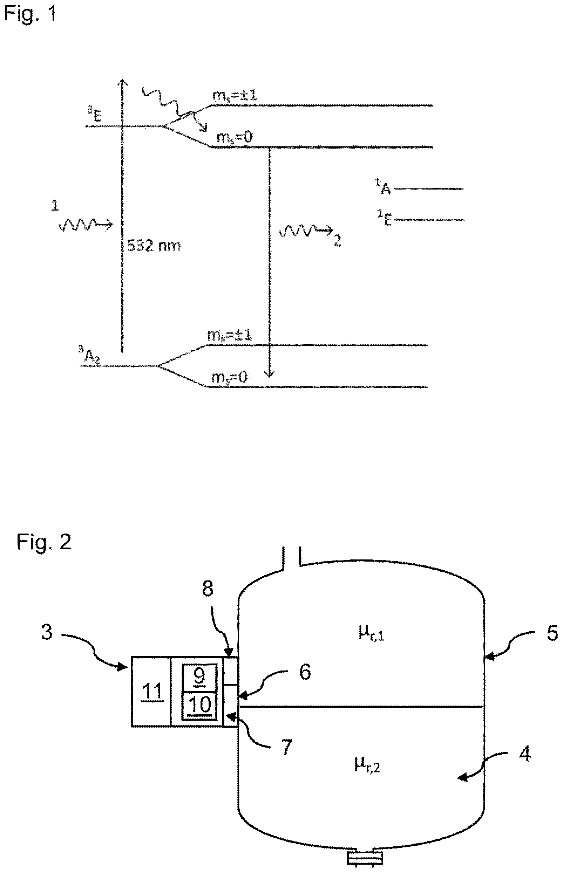

In Fig. 1 ist ein vereinfachtes Energieschema für ein negativ geladenes NV-Zentrum in einem Diamanten gezeigt, um die Anregung und die Fluoreszenz einer Fehlstelle in einem Kristallkörper beispielhaft zu erläutern. Die folgenden Überlegungen lassen sich auf andere Kristallkörper mit entsprechenden Fehlstellen übertragen.

Im Diamant ist typischerweise jedes Kohlenstoffatom mit vier weiteren Kohlenstoffatomen kovalent verbunden. Ein nitrogen vacancy-Zentrum (NV-Zentrum) besteht aus einer Fehlstelle im Diamantgitter, also einem unbesetzten Gitterplatz, und einem Stickstoffatom als einem der vier Nachbaratome. Insbesondere die negativ geladenen NV⁻-Zentren sind für die Anregung und Auswertung von Fluoreszenzsignalen von Bedeutung. Im Energieschema eines negativ geladenen NV-Zentrums findet sich neben einem Triplett-Grundzustand ³A ein angeregter Triplett-Zustand ³E, welche jeweils drei magnetische Unterzustände mₛ=0,±1 aufweisen. Weiterhin befinden sich zwei metastabile Singulett-Zustände ¹A und ¹E zwischen dem Grundzustand ³A und dem angeregten Zustand ³E.

Durch Anregungslicht 1 aus dem grünen Bereich des sichtbaren Spektrums, also z.B. ein Anregungslicht 1 mit einer Wellenlänge von 532 nm, findet eine Anregung eines Elektrons aus dem Grundzustand ³A in einen Vibrationszustand des angeregten Zustand ³E statt, welches unter Aussenden eines Fluoreszenz-Photons 2 mit einer Wellenlänge von 630 nm in den Grundzustand ³A zurückkehrt. Ein angelegtes Magnetfeld mit einer Magnetfeldstärke B führt zu einer Aufspaltung (Zeeman-Splitting) der magnetischen Unterzustände, so dass der Grundzustand aus drei energetisch separierten Unterzuständen besteht, von denen jeweils eine Anregung erfolgen kann. Die Intensität des Fluoreszenzsignals ist jedoch abhängig von dem jeweiligen magnetischen Unterzustand, von dem aus angeregt wurde, so dass anhand des Abstands der Fluoreszenzminima beispielsweise die Magnetfeldstärke B mithilfe der Zeeman-Formel berechnet werden kann. Im Rahmen der vorliegenden Erfindung sind weitere Möglichkeiten der Auswertung des Fluoreszenzsignals vorgesehen, wie beispielsweise die Auswertung der Intensität des Fluoreszenzlichts, welche dem angelegten Magnetfeld ebenfalls proportional ist. Eine elektrische Auswertung wiederum kann beispielsweise über eine Photocurrent Detection of Magnetic Resonance (engl. kurz PDMR) erfolgen. Neben diesen Beispielen zur Auswertung des Fluoreszenzsignals sind noch weitere Möglichkeiten vorhanden, welche ebenfalls unter die vorliegende Erfindung fallen.

In Fig. 2 ist eine erste beispielhafte Ausgestaltung der erfindungsgemäßen Sensorvorrichtung 3 zur Bestimmung und/oder Überwachung einer Prozessgröße, beispielsweise eines Füllstands oder eines Grenzstands, eines Mediums in einem Behälter dargestellt. Die Sensorvorrichtung 3 ist von außen an einer Wandung 13 des Behälters 5 angeordnet, welches teilweise mit einem Medium 4 befüllt ist, welchem eine relative magnetische Permeabilität µ_{r,2} zugeordnet ist. Oberhalb des Mediums befindet sich in der Regel Luft oder ein Gas mit der relativen magnetischen Permeabilität µ_{r,1}. Die Sensorvorrichtung 3 umfasst einen Kristallkörper 6 mit einer Fehlstelle 7, eine Anregeeinheit 9 zur Anregung der Fehlstelle 7, eine Detektionseinheit 10 zur Detektion des Fluoreszenzsignals des Kristallkörpers 6 und eine Auswerte-Einheit 11 zur Ermittlung mindestens einer Aussage über die Prozessgröße anhand des Fluoreszenzsignals. Als Kristallkörper 6 kann beispielsweise ein Diamant mit zumindest einer Stickstoff-Fehlstelle, Siliziumcarbid mit zumindest einer Silizium-Fehlstelle oder hexagonales Bornitrid mit zumindest einem Fehlstellen-Farbzentrum eingesetzt werden.

Weiterhin ist eine Magnetfeld-Einrichtung 8 vorgesehen, welche ein Magnetfeld im Bereich des Kristallkörpers 6 und im Bereich des sich innerhalb des Behälters 5 befindenden Mediums 4 erzeugt, so dass eine Änderung des Magnetfelds im Bereich des Kristallkörpers 6 verstärkt wird. Die Magnetfeld-Einrichtung 8 ist beispielsweise ein Permanentmagnet oder eine Spule und kann zumindest teilweise innerhalb der Spule oder zwischen zwei Endbereichen des Permanentmagneten angeordnet sein.

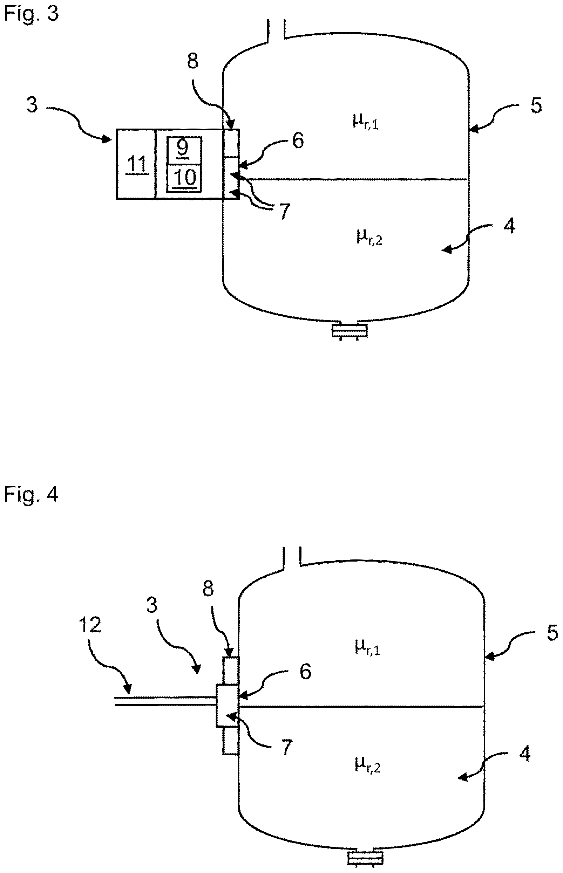

In Fig. 2 ist eine Sensorvorrichtung 3 gezeigt, welche außerhalb des Behälters, also nicht-invasiv, angeordnet ist. Als Alternative ist in Fig. 3 eine invasive, mit der Wandung 13 des Behälters 5 frontbündig abschließende Sensorvorrichtung 3 gezeigt. Beispielsweise wird die Sensorvorrichtung 3 mittels eines Adapters oder einer Fassung (nicht gezeigt) in die Wandung 13 des Behälters eingebracht. Der Kristallkörper aus Fig. 3 weist beispielhaft zwei Fehlstellen 7 auf, welche linear und senkrecht zum Boden an der Wandung 13 des Behälters 5 angeordnet sind. Auf diese Weise lässt sich eine Richtung der Änderung des Gradienten des Magnetfelds ermitteln.

In Fig. 4 ist eine dritte beispielhafte Ausgestaltung der Sensorvorrichtung 3 gezeigt, bei der eine Lichtleitfaser 12 das Anregesignal von der Anregeeinheit 9 zum Kristallkörper 6 und zur Leitung des Fluoreszenzsignals des Kristallkörpers 6 zur Detektionseinheit 10 eingesetzt wird. Die Anregeeinheit 9, die Detektionseinheit 10 und die Auswerteeinheit 11 sind in diesem Beispiel räumlich von dem Kristallkörper 6 getrennt angeordnet.

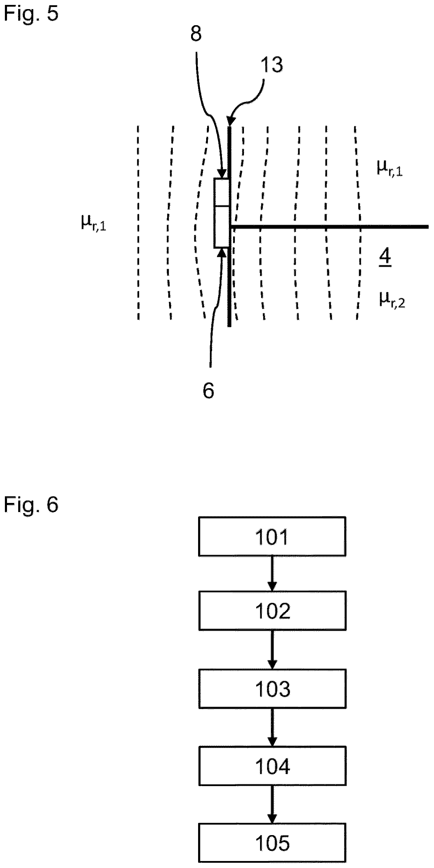

In Fig. 5 zeigt schematisch die Änderung des Magnetfelds zwischen dem Medium 4 mit der relativen magnetischen Permeabilität µ_{r,2} und der Luft mit der relativen magnetischen Permeabilität µ_{r,1} anhand der Magnetfeldlinien, die gestrichelt gezeichnet sind. Die Sensorvorrichtung 3 ist an der Wandung 13 des Behälters 5 angebracht. Der Einfachheit halber sind lediglich der Kristallkörper 6 und die Magnetfeld-Einrichtung 8 der Sensorvorrichtung 3 gezeigt. Durch den Unterschied der magnetischen Permeabilität des Mediums und der Luft werden die sonst parallel verlaufenden Magnetfeldlinien im Bereich der Grenzfläche zwischen Medium und Luft verzerrt. Die Magnetfeld-Einrichtung 8 verstärkt diese Verzerrung der Magnetfeldlinien, um diese anschließend mittels des Fluoreszenzsignals des Kristallkörpers 6 auslesen zu können.

In Fig. 6 ist das erfindungsgemäße Verfahren schematisch als Flussdiagramm dargestellt. In einem ersten Schritt 101 wird ein Magnetfeld im Bereich des Kristallkörpers 6 und im Bereich des Mediums 4 erzeugt. Anschließend erfolgt in eine zweiten Schritt 102 die Anregung der mindestens einen Fehlstelle 7 mittels der Anregeeinheit 9, woraufhin der Kristallkörper 6 ein Fluoreszenzsignal emittiert, welches im dritten Schritt 103 detektiert wird. Anhand des detektierten Fluoreszenzsignals wird im vierten Schritt 104 der Gradient des Magnetfelds ermittelt und schließlich im fünften Schritt 105 eine Aussage über die Prozessgröße anhand des Gradienten des Magnetfelds ermittelt. Der Gradient des Magnetfelds kann beispielsweise mittels mindestens zwei Fehlstellen und/oder mindestens zwei Kristallkörpern mit jeweils mindestens einer Fehlstelle ermitteln werden, welche linear und senkrecht zum Boden angeordnet sind.

### Bezugszeichenliste

- 1: Anregungslicht
- 2: Fluoreszenzlicht
- 3: Sensorvorrichtung
- 4: Medium
- 5: Behälter
- 6: Kristallkörper
- 7: Fehlstelle
- 8: Magnetfeld-Einrichtung
- 9: Anregeeinheit
- 10: Detektionseinheit
- 11: Auswerte-Einheit
- 12: Lichtleitfaser
- 13: Wandung

## Patentansprüche

1. Sensorvorrichtung (3) zur Bestimmung und/oder Überwachung einer Prozessgröße eines Mediums (4) in einem Behälter (5), umfassend
- einen Kristallkörper (6) mit zumindest einer Fehlstelle (7),
- eine Magnetfeld-Einrichtung (8) zur Erzeugung eines Magnetfelds, wobei die Magnetfeld-Einrichtung (8) derart angeordnet ist, dass mittels der Magnetfeld-Einrichtung (8) ein Magnetfeld im Bereich des Kristallkörpers (6) und im Bereich des sich innerhalb des Behälters (5) befindenden Mediums (4) erzeugbar ist, so dass eine Änderung des Magnetfelds im Bereich des Kristallkörpers (6) verstärkt wird, wobei der Kristallkörper (6) und die Magnetfeld-Einrichtung (8) von außen an einer Wandung (13) des Behälters (5) anordenbar sind,
- eine Anregeeinheit (9) zur optischen Anregung der zumindest einen Fehlstelle (7),
- eine Detektionseinheit (10) zur Detektion eines, magnetfeldabhängigen, Fluoreszenzsignals des Kristallkörpers (6),
- eine Auswerte-Einheit (11) zum Ermitteln zumindest einer Aussage über die Prozessgröße anhand des Fluoreszenzsignals.

2. Sensorvorrichtung nach Anspruch 1,
wobei es sich bei dem Kristallkörper (6) um einen Diamanten mit zumindest einer Stickstoff-Fehlstelle, um Siliziumcarbid mit zumindest einer Silizium-Fehlstelle oder um hexagonales Bornitrid mit zumindest einem Fehlstellen-Farbzentrum handelt.

3. Sensorvorrichtung nach zumindest einem der vorherigen Ansprüche, wobei die Magnetfeld-Einrichtung (8) einen Permanentmagnet oder eine Spule aufweist.

4. Sensorvorrichtung nach zumindest einem der vorherigen Ansprüche, wobei mindestens zwei Fehlstellen (7) und/oder mindestens zwei Kristallkörper (6) mit jeweils mindestens einer Fehlstelle (7) linear und senkrecht zum Boden an der Wandung (13) des Behälters (5) anordenbar sind.

5. Sensorvorrichtung nach zumindest einem der vorherigen Ansprüche, wobei mindestens eine Lichtleitfaser (12) zur Leitung des Anregesignals von der Anregeeinheit (9) zum Kristallkörper (6) und/oder zur Leitung des Fluoreszenzsignals des Kristallkörpers (6) zur Detektionseinheit (10) vorgesehen ist.

6. Sensorvorrichtung nach zumindest einem der vorherigen Ansprüche, wobei die Sensorvorrichtung (3) außerhalb des Behälters (5) anordenbar ist.

7. Sensorvorrichtung nach zumindest einem der vorherigen Ansprüche, wobei die Prozessgröße ein Füllstand und/oder ein Grenzstand des Mediums (4) in dem Behälter (5) ist.

8. Verfahren zur Bestimmung und/oder Überwachung einer Prozessgröße eines Mediums (4) in einem Behälter (5) mittels einer Sensorvorrichtung (3), wobei die Sensorvorrichtung (3) umfasst:
- einen Kristallkörper (6) mit zumindest einer Fehlstelle (7),
- eine Magnetfeld-Einrichtung (8) zur Erzeugung eines Magnetfelds, wobei die Magnetfeld-Einrichtung (8) derart angeordnet ist, dass mittels der Magnetfeld-Einrichtung (8) ein Magnetfeld im Bereich des Kristallkörpers (6) und im Bereich des sich innerhalb des Behälters (5) befindenden Mediums (4) erzeugbar ist, so dass eine Änderung des Magnetfelds im Bereich des Kristallkörpers (6) verstärkt wird, wobei der Kristallkörper (6) und die Magnetfeld-Einrichtung (8) von außen an einer Wandung (13) des Behälters (5) anordenbar sind,
- eine Anregeeinheit (9) zur optischen Anregung der zumindest einen Fehlstelle (7),
- eine Detektionseinheit (10) zur Detektion eines, magnetfeldabhängigen, Fluoreszenzsignals des Kristallkörpers (6),
- eine Auswerte-Einheit (11) zum Ermitteln zumindest einer Aussage über die Prozessgröße anhand des Fluoreszenzsignals,
wobei das Verfahren mindestens die folgenden Verfahrensschritte aufweist:
- Erzeugen eines Magnetfelds im Bereich des Kristallkörpers (6) und im Bereich des sich innerhalb des Behälters (5) befindenden Mediums (4) (101),
- Anregen der zumindest einen Fehlstelle (7) (102),
- Detektieren eines Fluoreszenzsignals des Kristallkörpers (6) (103),
- Ermitteln eines Gradienten des Magnetfelds anhand des Fluoreszenzsignals (104), und
- Ermitteln einer Aussage über die Prozessgröße anhand des Gradienten des Magnetfelds (105).

9. Verfahren nach Anspruch 8,
wobei der Gradient des Magnetfelds anhand von mindestens zwei Fehlstellen (7) und/oder mindestens zwei Kristallkörpern (6) mit jeweils mindestens einer Fehlstelle (7) ermittelt wird, welche linear und senkrecht zum Boden angeordnet sind.

## Claims

1. Sensor device (3) for determining and/or monitoring a
Process size of a medium (4) in a container (5), comprising
- a crystal body (6) with at least one defect (7),
- a magnetic field device (8) for generating a magnetic field, wherein the magnetic field device (8) is arranged such that a magnetic field can be generated in the region of the crystal body (6) and in the region of the medium (4) located inside the container (5) by means of the magnetic field device (8), so that a change in the magnetic field in the region of the crystal body (6) is amplified, wherein the crystal body (6) and the magnetic field device (8) can be arranged from the outside on a wall (13) of the container (5),
- an excitation unit (9) for optically exciting the at least one defect (7),
- a detection unit (10) for detecting a magnetic field-dependent fluorescence signal of the crystal body (6),
- an evaluation unit (11) for determining at least one statement about the process variable based on the fluorescence signal.

2. Sensor device according to claim 1, wherein the crystal body (6) is a diamond with at least one nitrogen defect, silicon carbide with at least one silicon defect or hexagonal boron nitride with at least one defect color center.

3. Sensor device according to at least one of the preceding claims, wherein the magnetic field device (8) comprises a permanent magnet or a coil.

4. Sensor device according to at least one of the preceding claims, wherein at least two defects (7) and/or at least two crystal bodies (6) each with at least one defect (7) are linear and
can be arranged perpendicular to the bottom on the wall (13) of the container (5).

5. Sensor device according to at least one of the preceding claims, wherein at least one optical fiber (12) is provided for conducting the excitation signal from the excitation unit (9) to the crystal body (6) and/or for conducting the fluorescence signal of the crystal body (6) to the detection unit (10).

6. Sensor device according to at least one of the preceding claims, wherein the sensor device (3) can be arranged outside the container (5).

7. Sensor device according to at least one of the preceding claims, wherein the process variable is a fill level and/or a limit level of the medium (4) in the container (5).

8. Method for determining and/or monitoring a process variable of a medium (4) in a container (5) by means of a sensor device (3), wherein the sensor device (3) comprises:
- a crystal body (6) with at least one defect (7),
- a magnetic field device (8) for generating a magnetic field, wherein the magnetic field device (8) is arranged such that a magnetic field can be generated in the region of the crystal body (6) and in the region of the medium (4) located inside the container (5) by means of the magnetic field device (8), so that a change in the magnetic field in the region of the crystal body (6) is amplified, wherein the crystal body (6) and the magnetic field device (8) can be arranged from the outside on a wall (13) of the container (5),
- an excitation unit (9) for optically exciting the at least one defect (7),
- a detection unit (10) for detecting a magnetic field-dependent fluorescence signal of the crystal body (6),
- an evaluation unit (11) for determining at least one statement about the process variable based on the fluorescence signal, the method comprising at least the following method steps:
- generating a magnetic field in the region of the crystal body (6) and in the region of the medium (4) (101) located within the container (5),
- stimulating at least one defect (7) (102),
- Detecting a fluorescence signal of the crystal body (6) (103),
- Determining a gradient of the magnetic field based on the fluorescence signal (104), and
- Determining a statement about the process variable based on the gradient of the magnetic field (105).

9. Method according to claim 8, wherein the gradient of the magnetic field is determined based on at least two defects (7) and/or at least two crystal bodies (6) each having at least one defect (7), which are arranged linearly and perpendicular to the ground.

## Revendications

1. Dispositif capteur (3) pour déterminer et/ou surveiller un
Taille de traitement d'un milieu (4) dans un récipient (5), comprenant
- un corps cristallin (6) présentant au moins un défaut (7),
- un dispositif à champ magnétique (8) pour générer un champ magnétique, le dispositif à champ magnétique (8) étant agencé de telle manière qu'un champ magnétique soit créé dans la zone du corps cristallin (6) et dans la zone à l'intérieur le corps cristallin (6) peut être généré au moyen du dispositif de champ magnétique (8) situé dans le récipient (5), de sorte qu'une modification du champ magnétique dans la zone du corps cristallin ( 6) est augmenté, le corps en cristal (6) et le dispositif de champ magnétique (8) pouvant être fixés à une paroi (13) depuis l'extérieur du récipient (5),
- une unité d'excitation (9) pour exciter optiquement le au moins un défaut (7),
- une unité de détection (10) pour détecter un signal de fluorescence dépendant du champ magnétique du corps cristallin (6),
- une unité d'évaluation (11) pour déterminer au moins une déclaration concernant la variable de processus sur la base du signal de fluorescence.

2. Dispositif capteur selon la revendication 1, dans lequel le corps cristallin (6) est un diamant avec au moins un défaut d'azote, du carbure de silicium avec au moins un défaut de silicium ou du nitrure de bore hexagonal avec au moins un centre de couleur défectueux.

3. Dispositif capteur selon au moins l'une des revendications précédentes, dans lequel le dispositif à champ magnétique (8) présente un aimant permanent ou une bobine.

4. Dispositif capteur selon au moins l'une des revendications précédentes, dans lequel au moins deux défauts (7) et/ou au moins deux corps cristallins (6) présentent chacun au moins un défaut (7) linéaire et
peut être disposé perpendiculairement au sol sur la paroi (13) du conteneur (5).

5. Dispositif capteur selon au moins l'une des revendications précédentes, dans lequel au moins une fibre optique (12) est prévue pour conduire le signal d'excitation de l'unité d'excitation (9) vers le corps cristallin (6) et/ou pour conduire le signal de fluorescence. du corps cristallin (6) à l'unité de détection (10).

6. Dispositif capteur selon au moins l'une des revendications précédentes, dans lequel le dispositif capteur (3) peut être disposé à l'extérieur du récipient (5).

7. Dispositif capteur selon au moins l'une des revendications précédentes, dans lequel la variable de processus est un niveau de remplissage et/ou un niveau limite du milieu (4) dans le récipient (5).

8. Procédé pour déterminer et/ou surveiller une grandeur de processus d'un milieu (4) dans un récipient (5) au moyen d'un dispositif capteur (3), le dispositif capteur (3) comprenant :
- un corps cristallin (6) présentant au moins un défaut (7),
- un dispositif à champ magnétique (8) pour générer un champ magnétique, le dispositif à champ magnétique (8) étant agencé de telle manière qu'un champ magnétique soit créé dans la zone du corps cristallin (6) et dans la zone à l'intérieur le corps cristallin (6) peut être généré au moyen du dispositif de champ magnétique (8) situé dans le récipient (5), de sorte qu'une modification du champ magnétique dans la zone du corps cristallin ( 6) est augmenté, le corps cristallin (6) et le dispositif de champ magnétique (8) pouvant être fixés à une paroi (13) depuis l'extérieur du récipient (5),
- une unité d'excitation (9) pour exciter optiquement le au moins un défaut (7),
- une unité de détection (10) pour détecter un signal de fluorescence dépendant du champ magnétique du corps cristallin (6),
- une unité d'évaluation (11) pour déterminer au moins une déclaration concernant la variable de processus sur la base du signal de fluorescence, le procédé comportant au moins les étapes de processus suivantes : - générer un champ magnétique dans la zone du corps cristallin (6) et dans la zone à l'intérieur du conteneur (5) située le milieu (4) (101),
- stimuler l'au moins un défaut (7) (102),
- Détection d'un signal de fluorescence provenant du corps cristallin (6) (103),
- Détermination d'un gradient du champ magnétique basé sur le Signal de fluorescence (104), et
- Détermination d'une déclaration concernant la variable de processus basée sur le gradient du champ magnétique (105).

9. Procédé selon la revendication 8, dans lequel le gradient du champ magnétique est déterminé à partir d'au moins deux défauts (7) et/ou d'au moins deux corps cristallins (6) présentant chacun au moins un défaut (7) disposés linéairement. et perpendiculaire au sol.
